# EUROPÄISCHE PATENTANMELDUNG

(11) **EP 4 345 479 A1**
(43) Veröffentlichungstag der Anmeldung: **03.04.2024**
(21) Anmeldenummer: 22198681.3
(22) Anmeldetag: 29.09.2022
(51) Int. Cl.: G01R 33/561, G01R 33/56, G01R 33/565

(54) **VERFAHREN ZUR ITERATIVEN REKONSTRUKTION VON BILDDATEN AUS MITTELS EINER MAGNETRESONANZANLAGE AUFGENOMMENEN MESSDATEN**

(71) Anmelder: Siemens Healthineers AG, 91301 Forchheim (DE)
(72) Erfinder: Zeller, Mario, 91054 Erlangen (DE)
(74) Vertreter: Siemens Healthineers Patent Attorneys

(57) **Zusammenfassung**

Bei einem erfindungsgemäßen Verfahren werden Bilddaten (BD) umfassende Ausgangsdaten (AD) ermittelt, indem auf mittels einer Magnetresonanzanlage (1) gemäß Nyquist unterabgetastet und mit einer in einem zentralen Bereich des k-Raums (Z) höheren Dichte als in peripheren Bereichen des k-Raums aufgenommene Messdaten wenigstens eine trainierte Rekonstruktionsfunktion (RkF) angewendet wird. Dabei umfasst die trainierte Rekonstruktionsfunktion (RkF) mindestens eine Konsistenzprüfung, die auf Messdaten (MD') basiert, welche aus den aufgenommenen und empfangenen Messdaten (MD) derart ermittelt werden, dass die ermittelten Messdaten (MD') im zentralen Bereich im k-Raum (Z), eine inhomogene Verteilung aufweisen und/oder im zentralen Bereich im k-Raum (Z) eine geringere Dichte als die empfangenen Messdaten (MD) aufweisen. Die Ausgangsdaten (AD) werden bereitgestellt.

Eine derartige Ermittlung von ermittelten Messdaten (MD') für Konsistenzprüfungen trainierter Rekonstruktionsfunktionen (RkF) kann mit nur geringem Aufwand durch Modifikation nur der der Konsistenzprüfung zuzuführenden Messdaten im k-Raum einer bereits bekannten trainierten Rekonstruktionsfunktionen (RkF) ermöglicht werden. Dabei ist es nicht erforderlich das Training der trainierten Rekonstruktionsfunktion (RkF) anzupassen und Artefakte in den rekonstruierten Bilddaten (BD) können vermieden oder zumindest reduziert werden.

## Beschreibung

Die Erfindung betrifft ein Verfahren zur iterativen Rekonstruktion von Bilddaten aus mittels einer Magnetresonanzanlage aufgenommenen Messdaten.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer sogenannten k-Raum-Matrix im Frequenzraum abgelegt. Aus einer mit einer gemäß dem Nyquist-Theorem ausreichend dicht mit Werten belegten k-Raum-Matrix ist z.B. mittels einer mehrdimensionalen Fourier-Transformation ein zugehöriges MR-Bild rekonstruierbar.

Sogenannte parallele Akquisitionstechniken (ppa), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, können eingesetzt werden, um z.B. die für die Aufnahme der Messdaten insgesamt nötige Messzeit zu verkürzen oder die Auflösung zu erhöhen. Die "fehlenden", d.h. nicht gemessenen aber für einen gemäß Nyquist vollständigen Satz an Messdaten erforderlichen, Messdaten werden hierbei auf Basis von Sensitivitätsdaten der verwendeten RF-Spulen und Kalibrierungsdaten und den gemessenen Messdaten ergänzt.

Während bei ppa-Techniken der k-Raum gemäß einem regelmäßigen Abtastmuster, das z.B. nur jede f-te gemäß Nyquist zu messende k-Raumzeile abtastet, unterabgetastet wird, werden bei sogenannten Compressed-Sensing(CS)-Verfahren möglichst unregelmäßige, insbesondere pseudo-zufällige, Abtastmuster des k-Raums eingesetzt und die "fehlenden" Messdaten werden mittels iterativer Rekonstruktionsfunktionen unter Hinzunahme von a-priori Wissen, welche als Randbedingungen in das Optimierungsproblem der Rekonstruktionsfunktion eingehen, bestimmt. CS- und ppa-Techniken können auch kombiniert werden.

Seit einigen Jahren ist es weiterhin bekannt, trainierte Rekonstruktionsfunktionen, die auf sogenannten deep-learning(DL)-Algorithmen basierende neuronale Netze einzusetzen, um Bilddaten aus mittels Magnetresonanztechnik unterabgetastet aufgenommenen Messdaten zu rekonstruieren.

Ein Überblick über die Prinzipien von ppa, CS und zugehörige iterative Rekonstruktionsfunktionen bis hin zu trainierten Rekonstruktionsfunktionen ist in dem Artikel von Knoll et al., "Deep-Learning Methods for Parallel Magnetic Resonance Imaging Reconstruction: A Survey of the Current Approaches, Trends, and Issues", IEEE Signal Processing Mag. 37(1): S.128-140 (2020), gegeben.

In iterativen Rekonstruktionsfunktionen wird ein Optimierungsproblem in mehreren Iterationen, insbesondere im Rahmen von trainierten Rekonstruktionsfunktionen manchmal auch Kaskaden genannt, gelöst. Dabei umfassen zumindest einigen Iterationen eine Konsistenzprüfung (engl. "data consistency", DC), die über einen Vergleich von durch die Rekonstruktionsfunktion bestimmten Messdaten mit gemessenen Messdaten sicherstellt, dass die Rekonstruktionsfunktion konsistent mit der durchgeführten Messung ist. Neben den gemessenen Messdaten werden in der Regel auch Informationen über das bei der Aufnahme der Messdaten verwendete Abtastmuster und weitere, die Physik der Aufnahme beschreibende Informationen sowie die Sensitivitätsdaten der verwendeten RF-Spulen (in einem häufig mit **E** oder **A,** manchmal auch anders bezeichneten Operator) bei der Konsistenzprüfung berücksichtigt.

Eine trainierte Rekonstruktionsfunktion mit verschiedenen Arten an Iterationen, die z.B. einerseits nur Näherungsschritte (dort "pre-iterations" genannt) und andererseits Regularisierungsterme umfassen (dort "iterations" genannt), ist in der US20220114771A1 beschrieben. Die dort beschriebenen Iterationen umfassen jeweils eine Konsistenzprüfung (dort auch "gradient update" genannt). Es sind auch Iterationen denkbar, die lediglich eine Konsistenzprüfung umfassen. Bei trainierten Rekonstruktionsfunktionen kann es sinnvoll sein, insbesondere im Anschluss an eine Reihe bereits erfolgter Iterationen, die Näherungsschritte und/oder Regularisierungsterme enthalten, zur weiteren Optimierung ein oder mehrere reine Konsistenzprüfungs-Iterationen durchzuführen.

Der Artikel von Hammernik et al., "Systematic evaluation of iterative deep neural networks for fast parallel MRI reconstruction with sensitivity-weighted coil combination", Magn Reson Med. 86: S.1859-1872 (2021) vergleicht verschiedene trainierte Rekonstruktionsfunktionen auch bezüglich ihrer Arten der Konsistenzprüfung.

Obwohl insbesondere mittels trainierten Rekonstruktionsfunktionen immer höhere Unterabtastungen und damit beschleunigte Messungen mit trotzdem grundsätzlich guter Bildqualität ermöglicht werden, können Artefakte, insbesondere sogenannte Banding Artefakte, die die diagnostische Qualität der so erstellten Bilddaten beeinträchtigen, auftreten wie es beispielsweise in dem Artikel von Dafazio et al., "MRI Banding Removal via Adversarial Training", 34th Conference on Neural Information Processing Systems (2020), arXiv:2001.08699, beschrieben werden, wo diese Artefakte durch Einsatz eines weiteren, adversen neuronalen Netzes bereinigt werden sollen.

Der Erfindung liegt die Aufgabe zugrunde, Artefakte in mittels iterativer Rekonstruktionsverfahren aus MR Messdaten rekonstruierten Bilddaten zu vermeiden, ohne zusätzliche neuronale Netze einsetzen zu müssen.

Der Erfindung liegt unter anderem die Erkenntnis zugrunde, dass im k-Raum eine inhomogene Dichte aufweisenden gemessenen Messdaten, eine Punkt-Spreiz-Funktion (engl. "point spread function") zugehörig ist, die verbreiterte Nebenkeulen (engl. "side lobes") hat. Da Punkt-Spreiz-Funktionen eine Ausbreitung von Aliasing-Artefakten von Abtastschemata beschreiben, zeigen derartige verbreiterte Nebenkeulen, dass eine Signalintensität eines Voxels in aus den Messdaten rekonstruierten Bilddaten nicht-konstante Beiträge zu einer Vielzahl an anderen Voxeln des gesamten Bildbereichs (engl. "field of view", FOV) liefert. Basiert eine Konsistenzprüfung einer trainierten Rekonstruktionsfunktion auf derartigen Messdaten mit einer Punkt-Spreiz-Funktion mit verbreiterten Nebenkeulen, wird die Konsistenz auch mit Bezug auf diese unerwünschten nichtkonstanten und zu Artefakten führenden Beiträge erhalten.

Die Aufgabe wird gelöst durch ein computerimplementiertes Verfahren zur Rekonstruktion von Bilddaten aus mittels einer Magnetresonanzanlage aufgenommenen Messdaten gemäß Anspruch 1, eine Rekonstruktionseinheit gemäß Anspruch 9, eine Magnetresonanzanlage gemäß Anspruch 10, ein Computerprogramm gemäß Anspruch 11, sowie ein computerlesbares Speichermedium gemäß Anspruch 12.

Ein erfindungsgemäßes computerimplementiertes Verfahren zur Rekonstruktion von Bilddaten aus mittels einer Magnetresonanzanlage aufgenommenen Messdaten umfasst die Schritte:
- Empfangen der Messdaten, wobei die Messdaten gemäß Nyquist unterabgetastet und mit einer in einem zentralen Bereich des k-Raums höheren Dichte als in peripheren Bereichen des k-Raums aufgenommen worden sind,
- Ermitteln von ermittelten Messdaten basierend auf den empfangenen Messdaten derart, dass die ermittelten Messdaten im zentralen Bereich im k-Raum, eine inhomogene Verteilung aufweisen und/oder im zentralen Bereich im k-Raum eine geringere Dichte als die empfangenen Messdaten, insbesondere eine der Dichte peripherer Bereiche der empfangenen Messdaten (MD) entsprechende Dichte, aufweisen,
- Anwenden wenigstens einer trainierten Rekonstruktionsfunktion auf Eingangsdaten, wobei die Eingangsdaten auf den empfangenen Messdaten basieren, und wobei Bilddaten umfassende Ausgangsdaten ermittelt werden, und wobei die trainierte Rekonstruktionsfunktion mindestens eine Konsistenzprüfung umfasst, welche auf den ermittelten Messdaten basiert,
- Bereitstellen der Ausgangsdaten.

Mit anderen Worten werden bei einem erfindungsgemäßen Verfahren Bilddaten umfassende Ausgangsdaten ermittelt, indem auf mittels einer Magnetresonanzanlage gemäß Nyquist unterabgetastet und mit einer in einem zentralen Bereich des k-Raums höheren Dichte als in peripheren Bereichen des k-Raums aufgenommene Messdaten wenigstens eine trainierte Rekonstruktionsfunktion angewendet wird. Dabei umfasst die trainierte Rekonstruktionsfunktion mindestens eine Konsistenzprüfung, die auf Messdaten basiert, welche aus den aufgenommenen und empfangenen Messdaten derart ermittelt werden, dass die ermittelten Messdaten im zentralen Bereich im k-Raum, eine inhomogene Verteilung aufweisen und/oder im zentralen Bereich im k-Raum eine geringere Dichte als die empfangenen Messdaten aufweisen. Die Ausgangsdaten werden bereitgestellt.

Erfindungsgemäß werden ermittelte Messdaten ermittelt, auf Basis derer zumindest eine von der trainierten Rekonstruktionsfunktion umfasste Konsistenzprüfung durchgeführt werden. Dabei wurden die ermittelten Messdaten derart ermittelt, dass diese einem Abtastmuster entsprechen, dessen Punkt-Spreiz-Funktion im Vergleich zu einer einem Abtastmuster mit vollständig aufgenommenen zentralen Bereich entsprechenden Punkt-Spreiz-Funktion verkleinerte Nebenkeulen aufweist. Auf diese Weise werden Artefakte, insbesondere Banding Artefakte, in aus den empfangenen Messdaten mit der eine erfindungsgemäße Konsistenzprüfung umfassenden trainierten Rekonstruktionsfunktion rekonstruierten Bilddaten vermieden oder zumindest reduziert.

Eine derartige Ermittlung von ermittelten Messdaten für die Konsistenzprüfung(en) einer trainierten Rekonstruktionsfunktion kann mit nur geringem Aufwand durch Modifikation nur der einer Konsistenzprüfung zuzuführenden Messdaten im k-Raum einer bereits bekannten trainierten Rekonstruktionsfunktionen in eine solche integriert werden. Dabei ist es nicht erforderlich das Training der trainierten Rekonstruktionsfunktion anzupassen.

Verschiedene Beispiele von Möglichkeiten einer derartigen Ermittlung von ermittelten Messdaten für die Konsistenzprüfung(en) einer trainierten Rekonstruktionsfunktion werden im Folgenden beschrieben.

Eine erfindungsgemäße Rekonstruktionseinheit umfasst eine Recheneinheit und einen Speicher, und ist dazu ausgebildet ein hierin beschriebenes Verfahren auszuführen.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Kompensationsgradientenbestimmungseinheit.

Ein erfindungsgemäßes Computerprogramm implementiert ein erfindungsgemäßes Verfahren auf einer Steuereinrichtung, wenn es auf der Steuereinrichtung ausgeführt wird. Beispielsweise umfasst das Computerprogramm Befehle, die bei der Ausführung des Programms durch eine Steuereinrichtung, z.B. eine Steuereinrichtung einer Magnetresonanzanlage, diese Steuereinrichtung veranlassen, ein erfindungsgemäßes Verfahren auszuführen. Die Steuereinrichtung kann in Form eines Computers gestaltet sein.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in einer Recheneinheit des Rechensystems ausgeführt wird.

Ein erfindungsgemäßes computerlesbares Speichermedium umfasst Befehle, die bei der Ausführung durch eine Steuereinrichtung, z.B. eine Steuereinrichtung einer Magnetresonanzanlage, diese veranlassen, ein erfindungsgemäßes Verfahren auszuführen.

Das computerlesbare Speichermedium kann als elektronisch lesbarer Datenträger ausgestaltet sein, welcher darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 ein schematisches Ablaufdiagram eines erfindungsgemäßen Verfahrens,
Figs. 2-6 schematisch dargestellte Beispiele von Abtastmustern von Messdaten im k-Raum auf Basis derer erfindungsgemäße Konsistenzprüfung durchgeführt oder wie sie als Messdaten empfangen werden können,
Fig. 7 eine erfindungsgemäße Rekonstruktionseinheit,
Figs. 8-9 schematisch dargestellte Beispiele von Punkt-Spreiz-Funktionen zu einigen in den Figuren 2-6 dargestellten Abtastmustern von Messdaten im k-Raum im Vergleich,
Fig. 10 eine schematisch dargestellte erfindungsgemäße Magnetresonanzanlage.

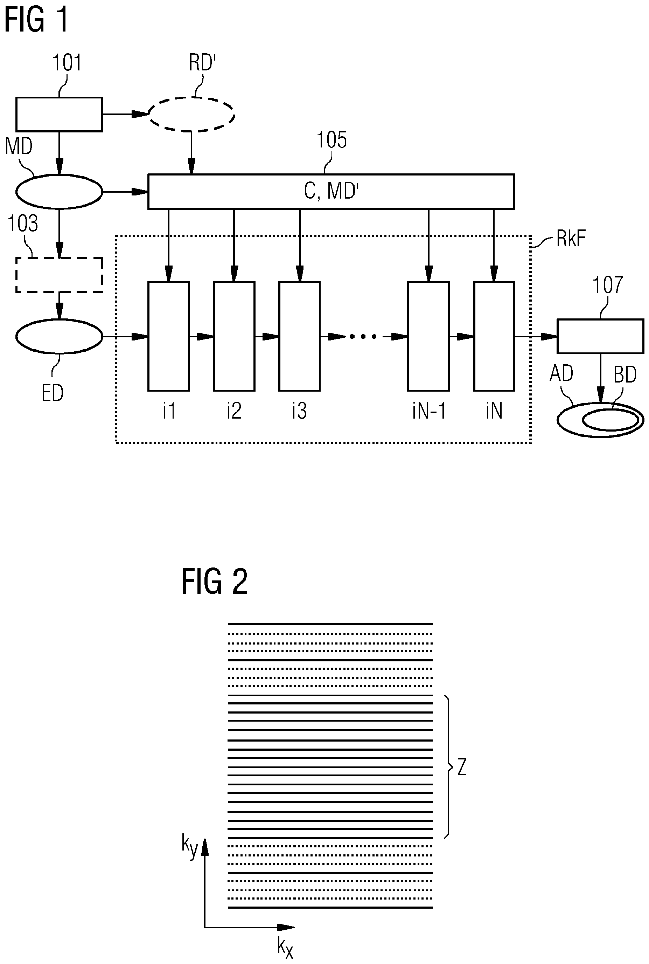

Figur 1 ist ein schematisches Ablaufdiagramm eines erfindungsgemäßen computerimplementierten Verfahrens zur Rekonstruktion von Bilddaten BD aus mittels einer Magnetresonanzanlage aufgenommenen Messdaten MD.

Es werden Messdaten MD empfangen, die gemäß Nyquist unterabgetastet und mit einer in einem zentralen Bereich Z des k-Raums höheren Dichte als in von dem zentralen Bereich Z verschiedenen, peripheren Bereichen des k-Raums aufgenommen worden sind. Die Messdaten MD wurden mittels einer Magnetresonanzanlage mit einem im k-Raum festlegenden Abtastmuster aufgenommen (Block 101). Beispielsweise können die Messdaten MD gemäß einem ppa-Verfahren aufgenommen worden sein.

Die empfangenen Messdaten können dabei z.B. gemäß einem Abtastmuster von entlang von in Ausleserichtung kx verlaufenden, parallelen k-Raumzeilen, die in Phasenkodierrichtung ky beabstandet sind, aufgenommen worden sein.

Die empfangenen Messdaten MD können auch Referenzdaten umfassen auf Basis derer Spulensensitivitätsdaten C von bei der Aufnahme der empfangenen Messdaten MD verwendeten Spulen ermittelt werden. Die Aufnahme von Referenzdaten verlangt eine (gemäß Nyquist) vollständige Abtastung, d.h. Aufnahme von Messdaten, in dem zentralen Bereich Z des k-Raums.

In dem in Figur 2 dargestellte Beispiel von Messdaten im k-Raum sind entlang von k-Raumzeilen gemessene Messdaten als durchgehende Linien dargestellt. Die punktiert dargestellten Linien entsprechen k-Raumzeilen, die zwar gemäß dem Theorem von Nyquist für eine vollständige Abtastung des k-Raums aufgenommen werden müssten, die aber tatsächlich nicht aufgenommen wurden. In dem dargestellten Beispiel wurde in einem in Phasenkodierrichtung zentralen Bereich Z der k-Raum vollständig abgetastet, in den in Phasenkodierrichtung peripheren Bereichen wurde jedoch nur jede vierte k-Raumzeile aufgenommen. Mit einem derartigen Abtastschema im k-Raum aufgenommene Messdaten könnten beispielsweise im Rahmen eines ppa-Verfahrens mit Beschleunigungsfaktor Vier (R=4) und, durch die vollständige Abtastung des zentralen Bereichs Z des k-Raums, mit integrierter Aufnahme von Referenzdaten, aus welchen z.B. Spulensensitivitätsdaten C ermittelt werden können, aufgenommen worden sein. Spulensensitivitätsdaten C können alternativ auch aus in einer separaten Aufnahme aufgenommenen Referenzdaten RD' ermittelt werden.

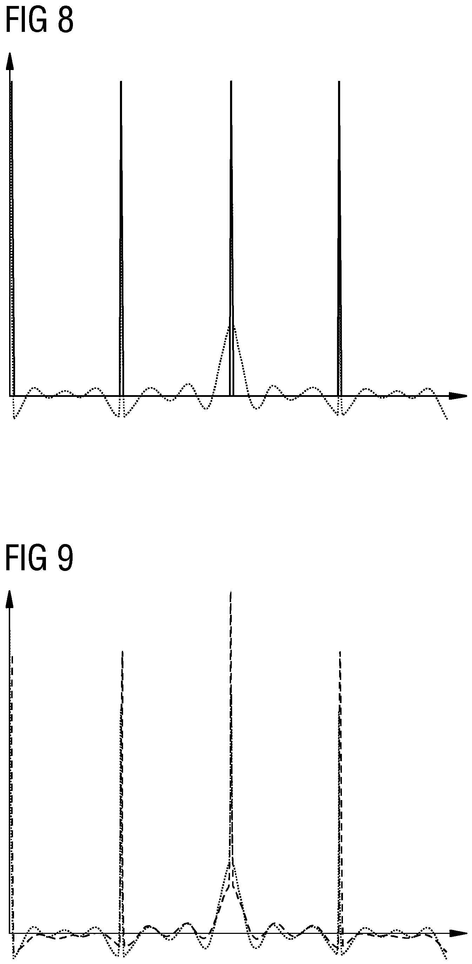

Eine einem Abtastmuster gemäß Figur 2 entsprechende Punkt-Spreiz-Funktion (PSF) ist beispielhaft in den Figuren 8 und 9 jeweils punktiert dargestellt. Die einem solchen Abtastmuster mit Beschleunigungsfaktor R=4 und vollständig abgetastetem zentralen Bereich Z des k-Raums entsprechende PSF weist (gemäß dem Beschleunigungsfaktor) vier distinkte Peaks auf, die jedoch durch die vollständige Abtastung des zentralen Bereichs Z des k-Raums und damit insgesamt stark unregelmäßige Abtastung des gesamten k-Raums deutlich verbreiterte Nebenkeulen aufweisen. Die verbreiterten Nebenkeulen zeigen an, dass eine Signalintensität eines Voxels von aus den gemäß diesem Abtastmuster aufgenommenen Messdaten rekonstruierten Bilddaten nicht-konstante Beiträge zu einer Vielzahl, möglicherweise allen, zumindest aber den meisten, anderen Voxeln im gesamten durch die Bilddaten dargestellten FOV leisten, was zu einer Bildung von Artefakten in den Bilddaten führt.

Auf Eingangsdaten ED, die auf den empfangenen Messdaten MD basieren, wird wenigstens eine trainierte Rekonstruktionsfunktion RkF angewandt, wobei Bilddaten BD umfassende Ausgangsdaten AD ermittelt werden. Die Eingangsdaten ED können hierbei empfangene Messdaten MD umfassen und ggf. auch (zusätzlich) aus den empfangenen Messdaten MD rekonstruierte erste Bilddaten (nicht dargestellt) sein (Block 103).

Die trainierte Rekonstruktionsfunktion RkF umfasst mehrere, mindestens zwei, Iterationen i1, i2, ..., iN (N≥2), und die trainierte Rekonstruktionsfunktion RkF umfasst mindestens eine Konsistenzprüfung. Insbesondere kann jede Iteration der trainierten Rekonstruktionsfunktion RkF eine Konsistenzprüfung umfassen. Auf diese Weise wird eine Konsistenz aller Iterationsergebnisse mit den physikalischen Bedingungen, unter welchen die empfangenen Messdaten MD aufgenommen wurden, und somit eine Konsistenz mit den Messdaten MD, sichergestellt.

Die trainierte Rekonstruktionsfunktion RkF kann beispielsweise eine trainierte Rekonstruktionsfunktion wie sie z.B. in den oben genannten Artikel von Knoll et al. und Hammernik et al. oder auch der US20220114771A1 beschrieben sind. Insbesondere kann die trainierte Rekonstruktionsfunktion RkF eine Reihe an sogenannten pre-iterationen, eine Reihe von Iterationen mit Regularisierungstermen und/oder eine Reihe von reinen Konsistenzprüfungs-Iterationen umfassen.

Basierend auf den empfangenen Messdaten MD werden ermittelte Messdaten MD' derart ermittelt, dass die ermittelten Messdaten (MD') im zentralen Bereich (Z) im k-Raum, eine inhomogene Verteilung aufweisen und/oder im zentralen Bereich (Z) im k-Raum eine geringere Dichte als die empfangenen Messdaten (MD), insbesondere eine der Dichte peripherer Bereiche der empfangenen Messdaten (MD) entsprechende Dichte, aufweisen (Block 105). Derartig ermittelte Messdaten MD' weisen eine zugehörige PSF auf, die zwar Nebenkeulen aufweisen kann, welche jedoch im Vergleich zu einer PSF, die einem unterabgetasteten Abtastmuster entspricht, das jedoch den zentralen Bereich Z des k-Raums vollständig abtastet, verkleinert sind. Verkleinerte Nebenkeulen zeigen weniger Beiträge von Signalintensitäten eines Voxels zu anderen Voxeln des FOVs und somit weniger Artefakte.

Die ermittelten Messdaten MD' können hierbei durch Entfernen von Messdaten der empfangenen Messdaten MD im zentralen Bereich Z des k-Raums bestimmt werden.

Wurden die empfangenen Messdaten MD beispielsweise gemäß einem ppa-Verfahren in peripheren Bereichen unterabgetastet, aber in einem zentralen Bereich Z vollständig aufgenommen, können Messdaten derart im zentralen Bereich Z entfernt werden, dass ein Abtastmuster entsteht, das im zentralen Bereich Z eine gleiche Dichte an Messdaten aufweist wie in peripheren Bereichen, also außerhalb des zentralen Bereichs Z.

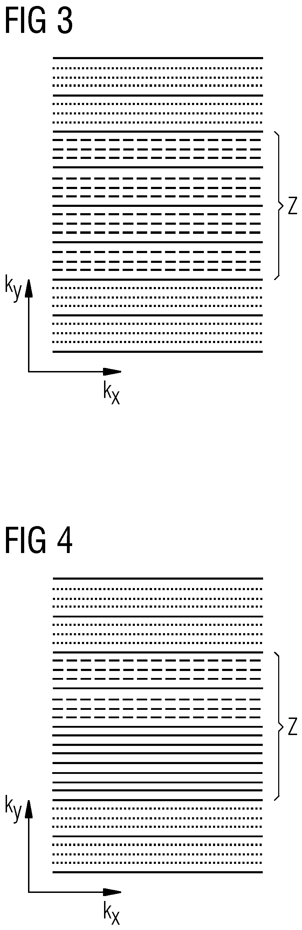

Wurden die empfangenen Messdaten MD also beispielsweise gemäß einem in Figur 2 Abtastmuster aufgenommen, können Messdaten derart entfernt werden, dass ein Abtastmuster entsteht, wie es in Figur 3 dargestellt ist. In Figur 3 werden analog zu Figur 2 Messdaten entlang von k-Raumzeilen aufgenommen, wobei aufgenommene Messdaten als durchgehende Linien, nicht aufgenommene Messdaten als punktierte Linien und entfernte Messdaten als gestrichelte Linien dargestellt sind. Es ergibt sich in diesem Fall ein reines unterabgetastetes Abtastmuster, das im gesamten k-Raum einem Beschleunigungsfaktor R=4 entspricht.

Eine einem Abtastmuster gemäß Figur 3 entsprechende PSF ist beispielhaft in Figur 8 mit durchgezogenen Linien im Vergleich zu der punktiert dargestellten PSF, die dem Abtastmuster der Figur 2 entspricht, dargestellt. Die einem solchen im gesamten k-Raum gleichmäßig unterabgetasteten Abtastmuster mit Beschleunigungsfaktor R=4 entsprechende PSF weist (gemäß dem Beschleunigungsfaktor) vier distinkte Peaks auf, die keine Nebenkeulen aufweisen. D.h. Beiträge von Signalintensitäten eines Voxels von aus den gemäß diesem Abtastmuster ermittelten Messdaten rekonstruierten Bilddaten zu anderen Voxeln sind nicht vorhanden oder zumindest sehr gering, was eine Bildung von Artefakten in den Bilddaten verhindert oder zumindest verringert.

Allerdings wird durch ein derartiges Entfernen von Messdaten, welches zu ermittelten Messdaten führt, welche im gesamten k-Raum gelichmäßig unterabgetastet sind, die Anzahl an zentralen Messdaten, welche bei einer Konsistenzprüfung berücksichtigt werden, deutlich reduziert. Dies kann wiederum zu einem verminderten Signal-zu-Rausch-Verhältnis und zu anderen Artefakten, z.B. sogenannten Ghosting-Artefakten, führen.

Bei einer Ermittlung von ermittelten Messdaten MD' können Messdaten der empfangenen Messdaten MD auch derart entfernt werden, dass die ermittelten Messdaten MD' im zentralen Bereich Z des k-Raums eine asymmetrische Verteilung, oder eine graduelle Verteilung, oder eine (pseudo-)zufällige Verteilung aufweisen.

Dabei kann sichergestellt werden, dass ermittelte Messdaten MD'das Zentrum des k-Raums umfassen. Im Zentrum des k-Raums, z.B. entlang der zentralen k-Raumzeile, aufgenommene Messdaten tragen besonders viel Signal bei. Ein Entfernen dieser könnte das Signal-zu-Rausch-Verhältnis negativ beeinflussen.

Dies soll im Folgenden wiederum am Beispiel der gemäß Figur 2 aufgenommenen Messdaten als empfangenen Messdaten MD veranschaulicht werden, ohne dass dies als Einschränkung zu lesen ist. Das beschriebene Vorgehen kann analog auf andere empfangene Messdaten, die gemäß Nyquist unterabgetastet und mit einer in einem zentralen Bereich Z des k-Raums höheren Dichte als in von dem zentralen Bereich Z verschiedenen, peripheren Bereichen des k-Raums aufgenommen worden sind, angewandt werden.

Wurden die empfangenen Messdaten MD also beispielsweise gemäß einem in Figur 2 Abtastmuster aufgenommen, können Messdaten derart entfernt werden, dass ein Abtastmuster entsteht, wie es in Figur 4 dargestellt ist. In Figur 4 werden analog zu Figur 2 Messdaten entlang von k-Raumzeilen aufgenommen, wobei aufgenommene Messdaten als durchgehende Linien, nicht aufgenommene Messdaten als punktierte Linien und entfernte Messdaten als gestrichelte Linien dargestellt sind. Es ergibt sich in diesem Fall ein Abtastmuster, das im zentralen Bereich Z des k-Raums asymmetrisch ist. Dabei kann insbesondere das durch das Entfernen von Messdaten entstehende Abtastmuster in einer Hälfte des zentralen Bereichs Z des k-Raums dem unterabgetastetes Abtastmuster der peripheren Bereiche entsprechen, in der anderen Hälfte des zentralen Bereiches Z des k-Raums jedoch weiter eine vollständige Abtastung erhalten bleiben. Somit ist die Dichte an Messdaten in dem zentralen Bereich Z des k-Raums weiter höher als in den peripheren Bereichen, jedoch geringer als in den empfangenen Messdaten MD.

Dadurch bleibt die Anzahl an zentralen Messdaten in den ermittelten Messdaten, gegenüber einer reinen Unterabtastung des gesamten k-Raums erhöht, wodurch Ghosting-Artefakten vermieden werden.

Eine einem Abtastmuster gemäß Figur 4 entsprechende PSF ist beispielhaft in Figur 9 mit gestrichelten Linien im Vergleich zu der punktiert dargestellten PSF, die dem Abtastmuster der Figur 2 entspricht, dargestellt. Die einem solchen im zentralen Bereich Z des k-Raums asymmetrisch unterabgetasteten Abtastmuster mit Beschleunigungsfaktor R=4 der Figur 4 entsprechende PSF weist (gemäß dem Beschleunigungsfaktor) vier distinkte Peaks auf, die zwar Nebenkeulen aufweisen, welche aber im Vergleich zu der PSF, die dem Abtastmuster der Figur 2 entspricht, deutlich verkleinert sind. Verkleinerte Nebenkeulen zeigen weniger Beiträge von Signalintensitäten eines Voxels zu anderen Voxeln des FOVs und somit weniger Artefakte.

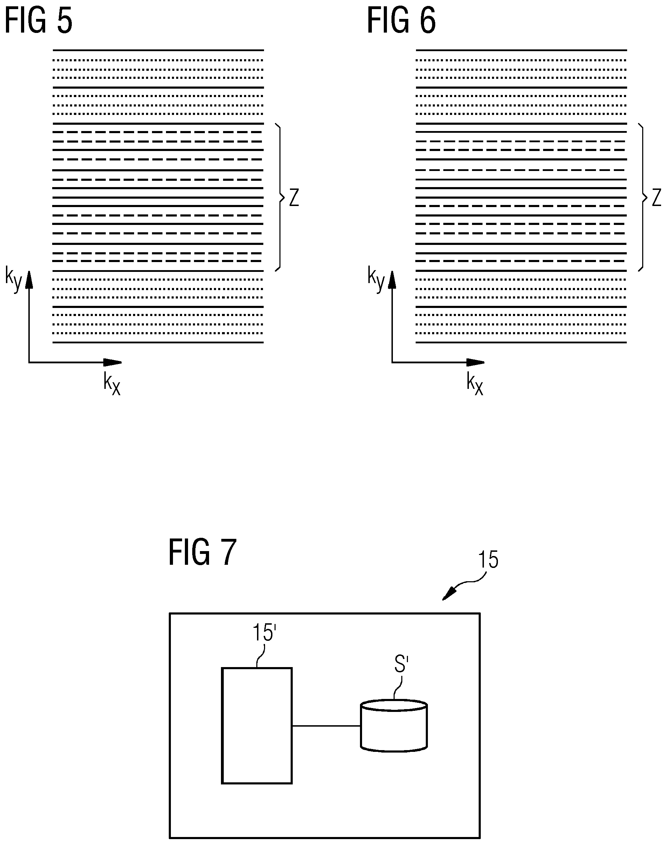

Wurden die empfangenen Messdaten MD also beispielsweise gemäß einem in Figur 2 Abtastmuster aufgenommen, können Messdaten auch derart entfernt werden, dass ein Abtastmuster entsteht, wie es in Figur 5 dargestellt ist. In Figur 5 werden analog zu Figur 2 Messdaten entlang von k-Raumzeilen aufgenommen, wobei aufgenommene Messdaten als durchgehende Linien, nicht aufgenommene Messdaten als punktierte Linien und entfernte Messdaten als gestrichelte Linien dargestellt sind. Es ergibt sich in diesem Fall ein Abtastmuster, das im zentralen Bereich Z des k-Raums eine graduelle Verteilung an Messdaten aufweist. Dabei kann insbesondere das durch das Entfernen von Messdaten entstehende Abtastmuster graduell von den peripheren Bereichen zum Zentrum des k-Raums hin mehr Messdaten aufnehmen. Somit ist die Dichte an Messdaten in dem zentralen Bereich Z des k-Raums weiter höher als in den peripheren Bereichen, jedoch geringer als in den empfangenen Messdaten MD.

Dadurch bleibt die Anzahl an zentralen Messdaten in den ermittelten Messdaten, gegenüber einer reinen Unterabtastung des gesamten k-Raums erhöht, wodurch Ghosting-Artefakten vermieden werden.

Eine einem Abtastmuster gemäß Figur 5 entsprechende PSF ist nicht dargestellt, die graduelle Verteilung der ermittelten Messdaten in dem zentralen Bereich Z des k-Raums führt jedoch zu einer weichen Überleitung von den peripheren Bereichen des k-Raums hin zum Zentrum des k-Raum, was ebenfalls eine Verkleinerung der Nebenkeulen einer einem Abtastmuster gemäß Figur 5 entsprechenden PSF im Vergleich zu der PSF, die dem Abtastmuster der Figur 2 entspricht, führt.

Wurden die empfangenen Messdaten MD wiederum beispielsweise gemäß einem in Figur 2 Abtastmuster aufgenommen, können Messdaten auch derart entfernt werden, dass ein Abtastmuster entsteht, wie es in Figur 6 dargestellt ist. In Figur 6 werden analog zu Figur 2 Messdaten entlang von k-Raumzeilen aufgenommen, wobei aufgenommene Messdaten als durchgehende Linien, nicht aufgenommene Messdaten als punktierte Linien und entfernte Messdaten als gestrichelte Linien dargestellt sind. Es ergibt sich in diesem Fall ein Abtastmuster, das im zentralen Bereich Z des k-Raums eine zufällige oder auch eine pseudo-zufällige Verteilung aufweist. Dabei können, insbesondere eine vorbestimmte Anzahl oder eine Anzahl, die zwischen einem vorbestimmten Minimalwert und einem vorbestimmten Maximalwert liegt, von Messdaten zufällig in dem zentralen Bereich Z des k-Raums entfernt werden. Die Dichte an Messdaten in dem zentralen Bereich Z des k-Raums ist hierbei weiter höher als in den peripheren Bereichen, jedoch geringer als in den empfangenen Messdaten MD.

Dadurch bleibt die Anzahl an zentralen Messdaten in den ermittelten Messdaten, gegenüber einer reinen Unterabtastung des gesamten k-Raums erhöht, wodurch Ghosting-Artefakten vermieden werden.

Eine einem Abtastmuster gemäß Figur 6 entsprechende PSF ist nicht dargestellt, die (pseudo-)zufällige Verteilung der ermittelten Messdaten in dem zentralen Bereich Z des k-Raums führt jedoch ebenfalls zu einer Verkleinerung der Nebenkeulen einer einem Abtastmuster gemäß Figur 6 entsprechenden PSF im Vergleich zu der PSF, die dem Abtastmuster der Figur 2 entspricht.

Empfangene Messdaten MD müssen den zentralen Bereich Z des k-Raums nicht vollständig abtasten. Es ist z.B. auch denkbar, dass die empfangenen Messdaten MD gemäß einem Abtastmuster im k-Raum aufgenommen wurden, das einem regelmäßigen Unterabtastmuster entspricht, welches mit zusätzlichen Messdaten im zentralen Bereich Z des k-Raums ergänzt wurde, ohne im zentralen Bereich Z des k-Raums eine vollständige Abtastung zu erreichen. Das regelmäßige Unterabtastmuster kann insbesondere ein Abtastmuster eines ppa-Verfahrens sein. Die zusätzlichen Messdaten, die jedoch nicht zu einer vollständigen Abtastung des zentralen Bereichs Z des k-Raums führen, können nicht als Referenzdaten für eine Ermittlung von Spulensensitivitätsdaten dienen. Es können jedoch auf bekannte Weise separat Referenzdaten RD' aufgenommen werden, aus welchen Spulensensitivitätsdaten ermittelt werden können.

Durch die zusätzlichen aufgenommenen Messdaten ist die Anzahl an zentralen Messdaten in den ermittelten Messdaten, gegenüber einer reinen Unterabtastung des gesamten k-Raums erhöht, wodurch Ghosting-Artefakten vermieden werden.

Dabei können die zusätzlichen aufzunehmenden Messdaten im zentralen Bereich Z des k-Raums derart gewählt werden, dass das entstehende Abtastmuster bereits eine inhomogene Verteilung in dem zentralen Bereich Z des k-raums aufweist. Beispielsweise können die zusätzlichen aufzunehmenden Messdaten so gewählt werden, dass insgesamt Messdaten aufgenommen werden, die im zentralen Bereich Z des k-Raums eine asymmetrische Verteilung, eine graduelle Verteilung, oder eine (pseudo-)zufällige Verteilung aufweisen. Ausgehend von einem ppa-Verfahren mit Beschleunigungsfaktor R=4 können beispielsweise zusätzliche Messdaten aufgenommen werden, sodass die entstehenden Abtastmuster den in den Figuren 3 bis 6 gezeigten Abtastmustern (wobei keine Messdaten entfernt wurden, sondern gestrichelt dargestellte Linien wie gepunktet dargestellte Linien nicht aufgenommen wurden) entsprechen oder analog zu diesen sind.

Aus derartig aufgenommenen empfangenen Messdaten MD ermittelte Messdaten MD' können den empfangenen Messdaten MD entsprechen.

Eine von der trainierten Rekonstruktionsfunktion umfasste Konsistenzprüfung, basiert auf den ermittelten Messdaten (MD'), d.h. die Konsistenz wird mit Bezug auf die aus den empfangenen Messdaten MD ermittelten Messdaten MD' durchgeführt, wodurch Artefakte, insbesondere Banding Artefakte, in durch die trainierte Rekonstruktionsfunktion ermittelten Bilddaten vermieden oder zumindest reduziert werden.

Konsistenzprüfungen können zusätzlich auf Basis von in den empfangenen Messdaten umfassten Referenzdaten ermittelten Spulensensitivitätsdaten C durchgeführt werden, die dafür auf bekannte Weise in den entsprechenden Operator der Konsistenzprüfung einbezogen werden. Die Referenzdaten können so zumindest indirekt über die aus ihnen ermittelten Spulensensitivitätsdaten C in der Konsistenzprüfung berücksichtigt werden, auch wenn nicht alle Referenzdaten von den ermittelten Messdaten MD' umfasst sind.

Die Ausgangsdaten AD werden bereitgestellt (Block 107) und können z.B. gespeichert, angezeigt oder weiterverarbeitet werden. Die von den Ausgangsdaten AD umfassten Bilddaten BD wurden so aus den empfangenen Messdaten MD rekonstruiert und sind durch die hierin beschriebene Konsistenzprüfung auf Basis von hierin beschriebenen aus den empfangenen Messdaten MD ermittelten Messdaten MD' von Artefakten befreit.

Figur 7 stellt schematische eine erfindungsgemäße Rekonstruktionseinheit 15 dar. Die Rekonstruktionseinheit 15 umfasst eine Recheneinheit 15' zum Durchführen von Rechenschritten für ein hierin beschriebenes Verfahren, welche Daten empfangen und senden kann. Zum Speichern von Daten, Zwischenergebnissen und/oder Ergebnissen umfasst die Rekonstruktionseinheit 15 weiterhin einen Speicher S'. Die Darstellung ist rein schematisch. Die Rekonstruktionseinheit 15 kann auch in einer Rechenstruktur ggf. mit verschiedenen Recheneinheiten, Schnittstellen und/oder Speichern integriert sein oder auf vorhandene Recheneinheiten und/oder Speicher zurückgreifen.

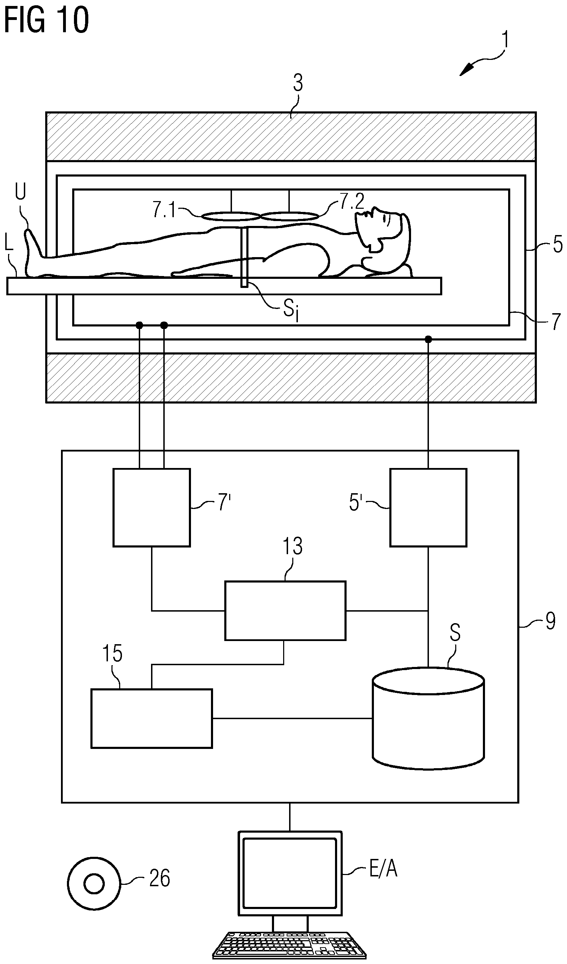

Figur 10 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 10 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht oder der Slab Sᵢ stellt ein exemplarisches Zielvolumen des Untersuchungsobjekts dar, aus dem Echosignale aufgenommen und als Messdaten erfasst werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Rekonstruktionseinheit 15, mit welcher eine erfindungsgemäße Rekonstruktion von Bilddaten ausgeführt werden kann. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogramms vorliegen, welches Befehle umfasst, die das beschriebene Verfahren auf einer Steuereinrichtung 9 ausführen. Ebenso kann ein computerlesbares Speichermedium vorliegen, welches Befehle umfasst, die bei der Ausführung durch eine Steuereinrichtung 9 einer Magnetresonanzanlage 1 diese veranlassen, das beschriebene Verfahren auszuführen.

## Patentansprüche

1. Computerimplementiertes Verfahren zur Rekonstruktion von Bilddaten (BD) aus mittels einer Magnetresonanzanlage (1) aufgenommenen Messdaten (MD), umfassend die Schritte:
- Empfangen der Messdaten (MD), wobei die Messdaten (MD) gemäß Nyquist unterabgetastet und mit einer in einem zentralen Bereich (Z) des k-Raums höheren Dichte als in peripheren Bereichen des k-Raums aufgenommen worden sind,
- Ermitteln von ermittelten Messdaten (MD') basierend auf den empfangenen Messdaten (MD) derart, dass die ermittelten Messdaten (MD') im zentralen Bereich (Z) im k-Raum, eine inhomogene Verteilung aufweisen und/oder im zentralen Bereich (Z) im k-Raum eine geringere Dichte als die empfangenen Messdaten (MD), insbesondere eine der Dichte peripherer Bereiche der empfangenen Messdaten (MD) entsprechende Dichte, aufweisen,
- Anwenden wenigstens einer trainierten Rekonstruktionsfunktion (RkF) auf Eingangsdaten (ED), wobei die Eingangsdaten (ED) auf den empfangenen Messdaten (MD) basieren, und wobei Bilddaten (BD) umfassende Ausgangsdaten (AD) ermittelt werden, und wobei die trainierte Rekonstruktionsfunktion (RkF) mindestens eine Konsistenzprüfung umfasst, welche auf den ermittelten Messdaten (MD') basiert,
- Bereitstellen der Ausgangsdaten (AD).

2. Verfahren nach Anspruch 1, wobei die empfangenen Messdaten (MD) Referenzdaten umfassen, auf Basis derer Spulensensitivitätsdaten (C) von bei der Aufnahme der empfangenen Messdaten (MD) verwendeten Spulen ermittelt werden.

3. Verfahren nach Anspruch 2, wobei Konsistenzprüfungen auf Basis der aus den Referenzdaten ermittelten Spulensensitivitätsdaten (C) durchgeführt werden.

4. Verfahren nach einem der Ansprüche 2 oder 3, wobei die ermittelten Messdaten (MD') durch Entfernen von Messdaten der empfangenen Messdaten (MD) im zentralen Bereich (Z) des k-Raums bestimmt werden.

5. Verfahren nach Anspruch 4, wobei Messdaten der empfangenen Messdaten (MD) derart entfernt werden, dass die ermittelten Messdaten (MD') im zentralen Bereich (Z) des k-Raums eine asymmetrische Verteilung, eine graduelle Verteilung, oder eine (pseudo-)zufällige Verteilung aufweisen.

6. Verfahren nach Anspruch 1, wobei die empfangenen Messdaten (MD) gemäß einem Abtastmuster im k-Raum aufgenommen wurden, das einem regelmäßigen Unterabtastmuster, insbesondere gemäß einem Abtastmuster eines Verfahrens einer parallelen Akquisitionstechnik (eines ppa-Verfahrens), entspricht, welches mit zusätzlichen Messdaten im zentralen Bereich (Z) des k-Raums ergänzt wurde, ohne im zentralen Bereich (Z) des k-Raums eine vollständige Abtastung zu erreichen.

7. Verfahren nach Anspruch 6, wobei die empfangenen Messdaten (MD) bereits im zentralen Bereich (Z) im k-Raum, eine inhomogene Verteilung aufweisen.

8. Verfahren nach einem der vorhergehenden Ansprüche, wobei ermittelte Messdaten (MD') das Zentrum des k-Raums umfassen.

9. Rekonstruktionseinheit (15) umfassend eine Recheneinheit (15') und einen Speicher (S'), dazu ausgebildet ein Verfahren nach einem der Ansprüche 1 bis 8 auszuführen.

10. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Rekonstruktionseinheit nach Anspruch 9.

11. Computerprogramm, umfassend Befehle, die bei der Ausführung des Programms durch einen Computer diesen veranlassen, das Verfahren nach einem der Ansprüche 1 bis 8 auszuführen.

12. Computerlesbares Speichermedium, umfassend Befehle, die bei der Ausführung durch einen Computer diesen veranlassen, das Verfahren nach einem der Ansprüche 1 bis 8 auszuführen.
